# EUROPÄISCHE PATENTSCHRIFT

(11) **EP 4 611 493 B1**
(45) Veröffentlichungstag und Bekanntmachung des Hinweises auf die Patenterteilung: **11.02.2026**
(21) Anmeldenummer: 24160500.5
(22) Anmeldetag: 29.02.2024
(51) Int. Cl.: H05K 3/12, B41F 33/00, B41F 15/44, B41F 15/08, B41F 15/36

(54) **VERFAHREN ZUR ÜBERWACHUNG DER DRUCKBEREITSCHAFT EINER DRUCKMASKE, COMPUTERPROGRAMM UND COMPUTERSYSTEM**
METHOD FOR MONITORING THE PRINTING READINESS OF A PRINTING MASK, COMPUTER PROGRAM AND COMPUTER SYSTEM
PROCÉDÉ DE SURVEILLANCE DE LA DISPONIBILITÉ DE PRESSION D'UN MASQUE D'IMPRESSION, PROGRAMME INFORMATIQUE ET SYSTÈME INFORMATIQUE

(43) Veröffentlichungstag der Anmeldung: 03.09.2025
(73) Patentinhaber: Siemens Aktiengesellschaft, 80333 München (DE)
(72) Erfinder: Wormuth, Dirk, 12203 Berlin (DE); Müller, Bernd, 16259 Falkenberg (DE); Wittreich, Ulrich, 16727 Velten (DE)
(74) Vertreter: Siemens Patent Attorneys

(56) Entgegenhaltungen:
- EP-A1- 3 480 585
- US-A1- 2004 218 808
- US-B1- 6 371 017

## Beschreibung

Die Erfindung betrifft ein Verfahren zur Überwachung der Druckbereitschaft einer Druckmaske nach Patentanspruch 1, ein Computerprogramm nach Patentanspruch 11 sowie ein Computersystem mit einem Computerprogramm nach Patentanspruch 12.

US2004218808 offenbart auch eine Methode zur Überwachung der Druckmaske zur Qualitätskontrolle, In Druckverfahren, die einen Schablonendruck einsetzen, wobei unter Schablonendruck auch ein Siebdruck mit abgedeckten Siebbereichen fällt, und wie er häufig in Bedrucken von Leiterplatten eingesetzt wird, hängt das Druckergebnis sehr stark von Verunreinigungen der Druckschablone ab. Mittels einer Druckfolie aus Metall und/oder Kunststoff (z. B. ein Drucksieb, eine Druckschablone oder eine Metallschablone) werden z. B. bei der Herstellung von elektronischen Komponenten höher viskose bis pastöse Stoffe (wie z. B. Lotpasten) auf einen Schaltungsträger appliziert (gedruckt). In diese gedruckte Lotpastendepots werden in einem nachfolgenden Prozess Bauelemente bestückt. In einem finalen Wärmeprozess verflüssigt sich dann die Lotpaste und verbindet die Bauelemente fest mit dem Leiterbild der Leiterplatte zu einer stoffschlüssigen Verbindung. Die Qualität dieser finalen Lötverbindung ist also sehr stark von der Qualität der gedruckten Lotpastendepots abhängig. Sind z. B. die Druckmasken infolge des steten Druckprozesses und dem Einsatz der Lotpaste verschmutzt, können Fehldrucke (die sich in Fehlstellen und Brücken beispielsweise äußern) entstehen. Bei dieser Beschreibung handelt es sich um eine beispielhafte Anwendung von Druckprozessen und dies wiederum im Bereich der Herstellung von elektronischen Komponenten. In diesem Bereich können neben den besagten Lotpastendepots auch elektronische Komponenten wie Dickschichtwiderstände oder Leiterstruktur gedruckt werden.

Innerhalb der Drucksysteme sind daher Reinigungsapparaturen integriert, die in regelmäßigen Zyklen die Unterseite und somit auch die Apertur-Innenfläche der Druckmasken (auch Druckfolien genannt) entweder trocken oder nass (mittels eines flüssigen Reinigungsmediums) reinigen. Die Reinigungsapparaturen verfügen meist über Papierrollen und eine Vakuumabsaugvorrichtung, die von unten an die Druckfolie gedrückt und motorisch entlanggeführt werden. Die Reinigungszyklen werden manuell in die Systeme eingetragen. Hierbei werden entweder Erfahrungswerte genutzt oder die Bestimmung erfolgt durch aufwändige Versuche im Vorfeld. Die Reinigungsapparaturen verfahren im Inneren der Drucksysteme unter den Druckfolien und können manuell schlecht überwacht werden.

Alternativ ist es üblich, in regelmäßigem Abstand eine größere Reinigung der Druckmaske in einer speziellen Reinigungsanlage vorzunehmen. Auch hier sind lediglich Erfahrungswerte dafür geeignet, um den Reinigungsfortschritt der Druckmaske zu überwachen. Dabei kommt es häufig vor, dass die Druckmaske durch den externen Reinigungsschritt ebenfalls nicht ausreichend gereinigt ist, und es kommt beim Wiedereinsetzen der Druckmaske in die Druckanlage zu Fehldrucken, die zu einem Ausschuss der Leiterplatte führen.

Die Aufgabe der Erfindung besteht darin, ein Verfahren zur Überwachung der Druckbereitschaft einer Druckmaske bereitzustellen, das dazu geeignet ist, Fehldrucke zu reduzieren und somit die Ausschussquote im Druckprozess zu verringern.

Die Lösung der Aufgabe besteht in einem Verfahren zur Überwachung der Druckbereitschaft einer Druckmaske mit den Merkmalen des Patentanspruchs 1 sowie in einem Computerprogramm nach Patentanspruch 11 und einem Computersystem nach Patentanspruch 12.

Das Verfahren zur Überwachung der Druckbereitschaft einer Druckmaske, die Abdeckbereiche und Aperturöffnungen aufweist, umfasst dabei folgende Schritte:
- Erzeugen einer Abbildung der Druckmaskenoberfläche
- Erfassung einer Thermografieaufnahme der Druckmaskenoberfläche
- Festlegen von Justierpunkten auf der Druckmaskenoberfläche, die auf der Abbildung und auf der Thermografieaufnahme identifizierbar sind,
- Überlagerung der Abbildung und der Thermografieaufnahme anhand der Justierpunkte,
- Vergleichen der Position von Temperaturanomalien I₁ auf der Druckmaskenoberfläche, die mittels der Thermografieaufnahme identifiziert werden mit der Position der Aperturöffnungen auf der Abbildung,
- Festlegen eines Temperaturintervalls für die Temperaturanomalien,
- Einleiten von Prozessbeeinflussungsmaßnahmen, wenn die Temperaturanomalie zumindest teilweise außerhalb des Temperaturintervalls liegt.

Es hat sich herausgestellt, dass nach einem Reinigungsprozess, wenn die Druckmaske nicht vollständig gereinigt ist, sich in den Aperturöffnungen entweder Reste der Reinigungsflüssigkeit und/oder Reste der Druckpaste befinden, die die Qualität eines weiteren Druckvorganges negativ beeinflussen können. Diese Reste sowohl der Paste bzw. der Reinigungsmittel weisen stets eine flüssige Phase auf. Die Reinigungsmittel sind per se flüssig, die Pasten weisen jeweils flüssige Bindemittelanteile auf, damit die gewünschte Pastenviskosität eingestellt wird. Aufgrund der Verdampfung dieser flüssigen Phasen in den Aperturöffnungen wird die dafür benötigte Verdampfungsenthalpie der Festkörperumgebung der Aperturöffnung entzogen, wodurch eine Temperaturerniedrigung in diesem Bereich, in und um die Aperturöffnung hervorgerufen wird. Mittels der Thermografieaufnahme werden diese verdampfungsinduzierten Temperaturschwankungen als Temperaturanomalien dargestellt, wodurch auf verunreinigungsbedingte Ursachen geschlossen werden kann. Diese Temperaturanomalien sind flächig ausgestaltet und sie liegen insbesondere im Umfeld der verunreinigten Aperturöffnungen vor.

Mit dieser Erkenntnis ist es gemäß der technischen Lehre des Patentanspruchs 1 möglich, eine auf der Thermografieaufnahme basierende Qualitätssicherung und Überwachung der Druckbereitschaft der Druckmaske vorzunehmen. Werden entsprechende Temperaturanomalien auf der Thermografieaufnahme identifiziert und mit der Abbildung der initialen Druckmaskenoberfläche verglichen, so werden Maßnahmen eingeleitet, die den Prozess und entsprechend die Qualität eines weiteren Druckprozesses positiv beeinflussen.

Die hier verwendeten Begriffe seien dabei wie folgt definiert:
Die Abbildung der Druckmaskenoberfläche, kann eine Konstruktionsdarstellung beispielsweise aus einem CAD-Programm sein, sie kann aber auch eine fotographische Abbildung der real existierenden Druckmaske bzw. deren Oberfläche sein. Sie zeigt demnach die Druckmaske in einem funktionsfähigen in der Regel optimalen Ausgangszustand. Die Abbildung ist in einem Computersystem, beispielsweise in einer Anlagensteuerung der Druckanlage oder einer Reinigungsanlage wie beispielsweise in einer Siemens S7 1500 und/oder in ihren Peripheriegeräte hinterlegt oder sie wird direkt nach der Aufnahme dort hinterlegt. Das Computersystem kann auch in einer Computer-Cloud angeordnet sein. In der Regel wird die Abbildung in Form von Bildpunkten in das Computersystem bzw. in die Anlagensteuerung übertragen. Das gleiche gilt auch für die Thermografieaufnahme, die bevorzugt in Form einer Infrarot-Aufnahme durchgeführt wird. Auch einzelne punktförmige Temperaturmessungen, beispielsweise mit einem Thermoelement sind Thermografieaufnahmen, wenn ein betrachteter Messpunkt bezüglich der Abbildung lokalisierbar ist.

Justierpunkte sind geometrische Gebilde (nicht nur Punkte im mathematischen Sinne) auf der Applikationsoberfläche, die ausreichend charakteristisch sind, um eine eindeutige Zuordnung der Darstellung der Abbildung und der Thermografieaufnahme zu gewährleisten. Dabei sind zur eindeutigen Justierung bevorzugt mindestens zwei Justierpunkte vorgesehen. Es kann aber auch nur ein Justierpunkt als geometrisches Gebilde vorgesehen sein, der in seiner geometrischen Form so ausgestaltet ist, dass einen eine eindeutige planare Justierung der Abbildung und der Thermografieaufnahme zueinander ermöglicht wird. Dies kann beispielsweise durch einen Justierpunkt in Form eines Kreuzes erfolgen. Der Begriff Justierpunkt schließt somit auch den Singular in Form eines Justierpunktes (Justiergeometrie) mit ein. Dabei können beispielsweise die Aperturöffnungen der Druckmaske bereits als Justierpunkte dienen. Anhand der festgelegten Justierpunkte können die Abbildung der Druckmaskenoberfläche und die Thermografieaufnahme übereinandergelegt, das heißt überlagert werden. Hierbei wird der Begriff Überlagern im übertragenen Sinne verwendet, analog zu einem Bild und einer transparenten Folie. Bei rein digital vorliegenden Bildern besteht das Überlagern in einem elektronischen Vergleichen, beispielsweise durch ein Bildanalyse-Programm, wobei die Aufnahme und die Abbildung anhand der festgelegten Justierpunkte mittels einzelner Bildpunkte oder Bildpunktcluster ausgewertet werden.

Temperaturanomalien sind auf der Thermografieaufnahme sichtbare Punkte oder Flächen, die gegenüber der Umgebungsfläche einen Temperaturunterschied aufweisen. Dabei tritt in der Regel innerhalb einer Temperaturanomalie nicht zwingend eine konstante Temperatur auf, vielmehr liegt dort eine Temperaturintervall vor, das sich mit einem Temperaturintervall, das die Umgebungsflächen aufweisen, nicht oder nur teilweise schneidet. Daher ist für die Bestimmung einer Grenze zwischen der Temperaturanomalie und der Umgebungsfläche die Festlegung einer Schwelltemperatur also ein Temperaturschwellwert zweckmäßig. Dieser Temperaturschwellwert kann auch eine Grenztemperatur eines Temperaturintervalls sein oder als unendlich kleines Temperaturintervall angesehene werden. Somit ist es möglich, ein Temperaturintervall für die Temperaturanomalien und ein Temperaturintervall der Abdeckbereich der Druckmaske miteinander zu vergleichen. Dabei kann es sein, dass die beiden genannten Temperaturintervalle so zueinander liegen, dass das Temperaturintervall der Temperaturanomalien I₁ innerhalb des Temperaturintervalls der Abdeckfläche I₂ oder eines anderen als akzeptabel definierten Temperaturintervalls I₂ liegt. In diesem Fall ist keine prozessbeeinflussende Maßnahme nötig. Für den Fall, dass sich die Intervalle I₁ und I₂ überschneiden, kann eine Überschneidungsgrad definiert werden bei dessen Überschreiten oder Unterschreiten eine Prozessbeeinflussungsmaßnahme eingeleitet wird. Bei vollständigen Nichtüberlagern von I₁ und I₂ werden die Prozessbeeinflussungsmaßnahmen durchgeführt. Eine übliche Prozessbeeinflussungsmaßnahme, die bei Auftreten der Temperaturanomalien und einer Identifizierung für ein kritisches Maß dieser Temperaturanomalien anhand eines **festgelegten** Temperaturintervalls angewandt wird, ist üblicherweise die Reinigung oder die Trocknung bzw. Nachtrocknung der Druckmaske. Alternativ können auch je nachdem wie stark die Verunreinigung ist, die detektiert wird, Prozessbeeinflussungsmaßnahmen wie eine Veränderung der Rakelgeschwindigkeit oder eines Rakeldrucks der Druckanlage erfolgen.

Da sich die Temperaturanomalien auf die Verdampfung und die dabei benötigte Verdampfungsenthalpie beziehen, verändern sich die Temperaturanomalien in der Regel mit der Zeit. Daher ist es zweckmäßig, einen bestimmten Zeitpunkt festzulegen, der nach einer definierten Dauer ab Eintreten eines Ereignisses zum Zeitpunkt t₀ liegt. Zu diesem Zeitpunkt t₁ wird dann die Thermografieaufnahme durchgeführt. Dies ist zweckmäßig, um ein vergleichbares Maß für die auf die Thermografieaufnahme bestimmten Temperaturanomalien zu definieren. Dabei kann das Ereignis beispielsweise das Ende eines Trocknungsprozesses oder das Ende eines letzten Druckvorganges, beispielsweise der Rakelbewegung, sein. Es hat sich ebenfalls herausgestellt, dass zwischen dem Zeitraum t₀ und t₁ eine messbare Veränderung der Temperaturanomalien eintritt, weshalb es auch zweckmäßig sein kann während dieses Zeitraums mehrere Thermografieaufnahmen zu machen. Darunter fällt auch ein Thermografieaufnahme-Video während dieses Zeitraums.

Dabei ist es wiederum zweckmäßig, dass ein Referenzverlauf einer Temperatur-Zeit-Kurve an einer definierten Aperturöffnung aufgenommen wird und mit dem betrachteten Temperatur-Zeit-Verlauf der Thermografieaufnahme verglichen wird. Auch hier gilt das, was zu den Intervallen der einzelnen Thermografieaufnahmen, dem Intervall I₁ und I₂ beschrieben ist, gleichermaßen, lediglich im zeitlichen Verlauf. Hier wird ein Referenzverlauf bei einer optimal gereinigten Druckmaske vorgenommen, diese wird mit dem aktuell gemessenen Verlauf (einschließlich möglicher Intervalle) verglichen, wobei Rückschlüsse über die Verunreinigung gezogen werden können. Diese Rückschlüsse lassen sich analog oben beispielsweise dadurch definieren, dass das Temperaturintervall als ein Toleranzbereich des Referenzverlaufes definiert wird und eine Maßnahme dann eingeleitet wird, wenn der betrachtete Temperatur-Zeit-Verlauf zumindest teilweise außerhalb dieses Toleranzbereiches liegt.

Ebenfalls zweckmäßig ist es, dass eine Anlagensteuerung vorgesehen ist und eine elektronische Auswertung und Überlagerung der Abbildung und der Thermografieaufnahme auf einem Computersystem erfolgt, das an die Anlagensteuerung angeschlossen ist oder in diese integriert ist. Dies weist den Vorteil auf, dass die Auswertung der beschriebenen Thermografieaufnahmen direkt vor Ort an der Anlagensteuerung vorgenommen werden können, wobei die Anlagensteuerung wie beispielsweise eine Siemens S 7-1500 für derartige Aufgaben und die daraus resultierenden Maßnahmen zur Prozessbeeinflussung, geeignet ist.

Dabei ist es ebenfalls zweckmäßig, dass das Verfahren in einer Druckanlage oder in einer Reinigungsanlage zur Reinigung von Druckmasken durchgeführt wird.

Besonders vorteilhaft lässt sich das Verfahren auf Druckanlagen anwenden, die zum Bedrucken von Leiterplatten mit einer Lotpaste dienen.

Ein weiterer Bestandteil der Erfindung ist ein Computerprogramm, das einen digitalen Zwilling zur Steuerung eines Verfahrens zur Überwachung der Druckbereitschaft einer Druckmaske nach einem Ansprüche 1 bis 10 umfasst. In diesem Computerprogramm ist die Abbildung als digitaler Zwilling vorliegend und die Aperturöffnung sowie die Justierpunkte sind als Bestandteil der digitalen Abbildung gespeichert. Die Thermografieaufnahme ist im Computerprogramm einlesbar.

Dieses Computerprogramm mit dem digitalen Zwilling der Abbildung und der eingelesenen Thermografieaufnahme weist den Vorteil auf, dass die Anlagensteuerung direkt zur Durchführung des beschriebenen Verfahrens geeignet ist und eine gegenüber dem Stand der Technik verbesserte Überwachung der Druckbereitschaft einer Druckmaske ermöglicht wird und somit der Ausschuss bei der Produktion, die mit der Druckanlage vorgenommen wird, verringert wird. Ferner ist ein Bestandteil der Erfindung ein Computersystem, das ein Computerprogramm nach Patentanspruch 11 umfasst.

Weitere Ausgestaltungsformen der Erfindung und weitere Merkmale werden anhand der folgenden Figuren näher erläutert. Dabei handelt es sich um rein schematische Ausgestaltungen der Erfindung, die keine Einschränkung des Schutzbereiches darstellen. Sie sind rein exemplarischer Natur. Merkmale in unterschiedlicher Ausgestaltungsform aber mit der gleichen Bezeichnung werden dabei mit denselben Bezugszeichen versehen.

Dabei zeigen:
- Figur 1: eine schematische Querschnittsdarstellung einer Druckanlage,
- Figur 2: eine schematische Darstellung einer Reinigungsanlage für Druckmasken,
- Figur 3: eine Abbildung einer Druckmaske,
- Figur 4: eine vergrößerte Darstellung des Ausschnittes IV in Figur 3,
- Figur 5: eine Thermografieaufnahme, die mit der vergrößerten Abbildung gemäß Figur 4 korrespondiert,
- Figur 6: eine Thermografieaufnahme analog Figur 5 mit einem anderen Verunreinigungszustand der Druckmaske,
- Figur 7: eine schematische Querschnittsdarstellung einer Druckmaske mit Verunreinigungen in Form von Reinigungsmitteln und einer Infrarotkamera zur Begutachtung der Oberfläche,
- Figur 8 a-c: Querschnitte durch eine Druckmaske mit unterschiedlichen Verunreinigungsgraden in den Aperturöffnungen mit den jeweils korrespondierenden Thermografieaufnahmen,
- Figur 9 a-c: die Thermografieaufnahmen aus Figur 8, die hier wiederum mit einem bestimmten Temperatur-Zeit-Verlauf korrespondieren.

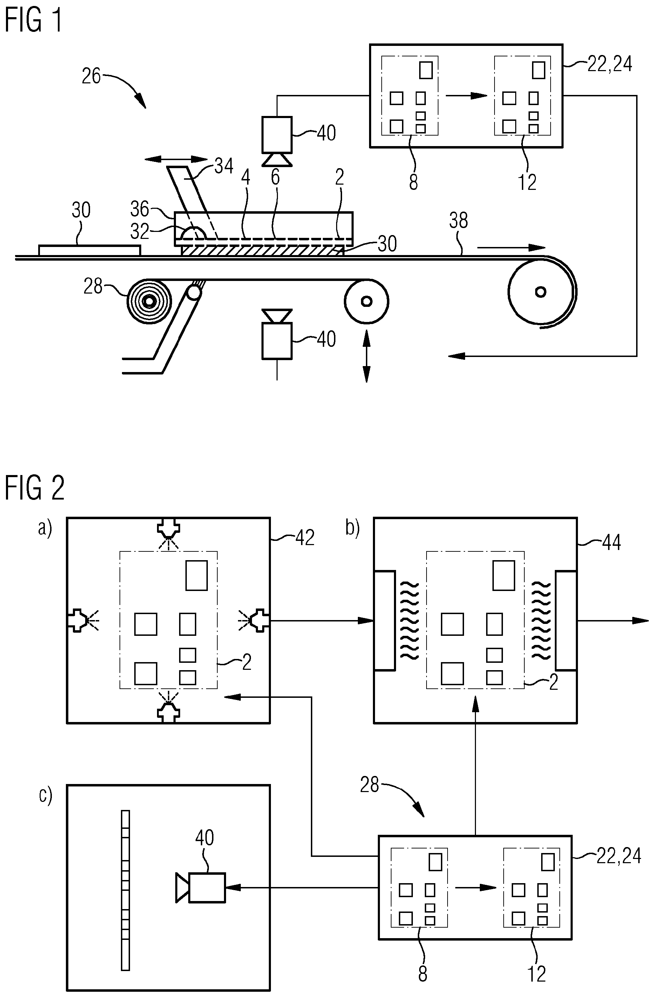

In Figur 1 ist zunächst schematisch eine Druckanlage 26 und ein darauf durchgeführter Druckprozess beschrieben. Hierbei wird auf eine Leiterplatte 30, die auf einem Förderband 38 transportierbar gelagert ist, mittels eines Rakels 34 eine Druckpaste 32 durch eine Druckschablone 2 auf die Leiterplatte 30 aufgedruckt. Dabei ist die Druckschablone 2 in einem Druckrahmen 36 eingespannt. Unterhalb der Druckmaske 2 und dem Druckrahmen 36 ist stark vereinfacht eine Reinigungsanlage 28 skizziert, die dazu geeignet ist, während des Druckprozesses eine Zwischenreinigung der Druckplatten 2 durchzuführen, wobei ein Reinigungsmittel auf ein Papiertuch gesprüht wird und das Papiertuch an die Druckplatte 2 angepresst wird und über diese hinweggefahren wird. Soweit handelt es sich um eine aus dem Stand der Technik bekannte Technologie.

Über den Stand der Technik hinaus geht die Anordnung von Infrarotkameras 40, wobei in diesem Beispiel zwei unterschiedlich angeordnete Infrarotkameras 40 dargestellt sind. Eine ist dazu geeignet, eine Draufsicht auf die Druckmaske 2 vorzunehmen, die andere Infrarotkamera 40 ist in der Lage eine Thermografieaufnahme von unten aufzunehmen. Es wird grundsätzlich nur eine Infrarotkamera 40 benötigt, zur Veranschaulichung der verschiedenen Anordnungsmöglichkeiten sind in Figur 1 zwei Kameras angeordnet, wobei dies zur besseren und redundanten Überwachung auch grundsätzlich zweckmäßig sein kann.

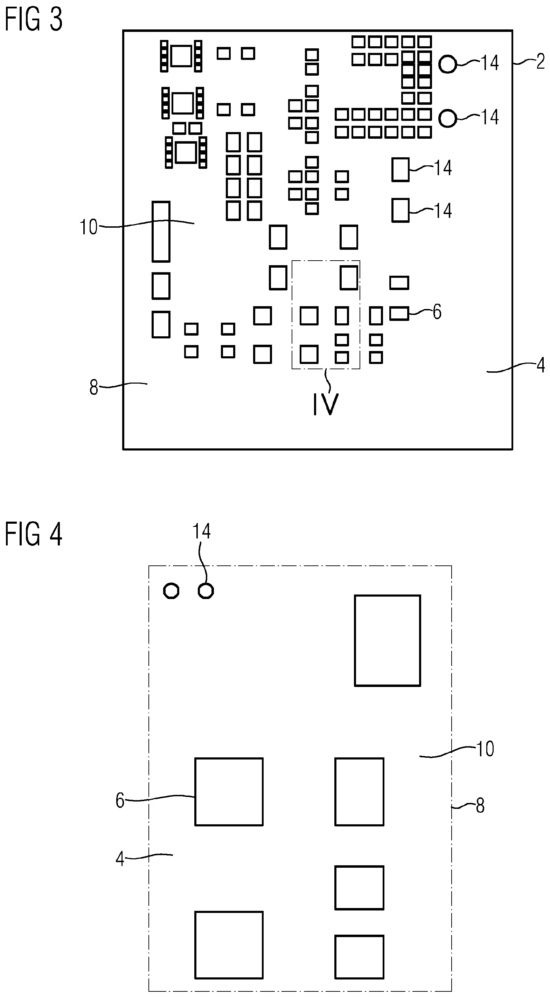

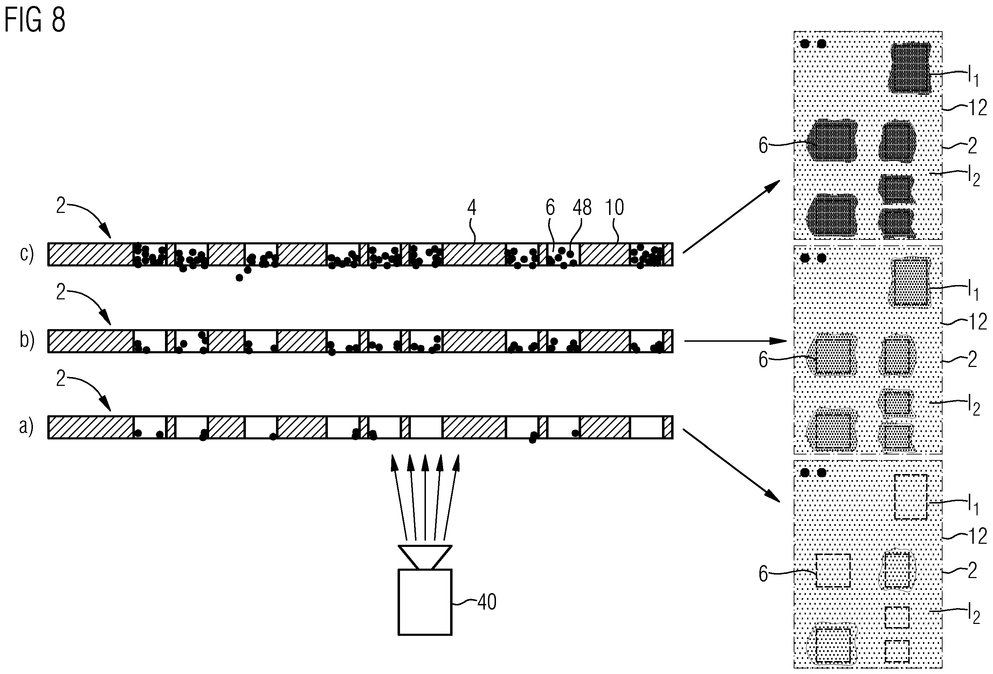

Ferner umfasst die Druckanlage eine Anlagensteuerung 22, in der ein Computersystem 24 integriert ist. In der Anlagensteuerung 22 ist eine Abbildung 8 der Druckplatte hinterlegt. Bei der Abbildung 8 kann es sich einerseits um eine digitale fotografische Aufnahme einer Druckplatte 2 im Ausgangszustand, also im optimalen Bearbeitungszustand handeln. Es ist jedoch auch zweckmäßig, CAD-Daten der Druckplatte 2 als Abbildung 8 in der Anlagensteuerung 22 zu hinterlegen. Durch die Infrarotkamera 40 wird ferner eine Thermografieaufnahme 12 erzeugt, die ebenfalls in die Anlagensteuerung 22 eingespeist wird und mit der Abbildung 8 elektronisch überlagert wird. Dies ist mit dem gebogenen Pfeil zwischen der Abbildung 8 und der Thermografieaufnahme 12 in Figur 1 schematisch veranschaulicht. Dabei handelt es sich bei dem Begriff Überlagern um eine elektronische Auswertung, wobei anhand von Justierpunkten 14, die beispielweise in den Figuren 3 und 4 dargestellt sind, die Abbildung 8 mit der Thermografieaufnahme 12 übereinander geschoben wird, sodass eine eindeutige Überdeckung der entsprechenden und korrespondierenden Bereiche sichergestellt ist. Über die detaillierte Auswertung wird bezüglich der weiteren Figuren noch näher eingegangen.

In Figur 2 ist eine schematische Darstellung einer Reinigungsanlage für Druckmasken 2 gegeben. Hierzu erfolgt zunächst eine Spülung 42 der Druckmaske 2, sodass mittels eines Reinigungsmittels die Druckpaste von der Schablone, insbesondere aus den Aperturöffnungen 6 herausgespült wird. Anschließend erfolgt eine Trocknung 44, was bisher auch gemäß dem Stand der Technik üblich ist. Grundsätzlich kann auch hier eine Papierreinigung erfolgen.

Vom Stand der Technik unterscheidet sich die Figur 2 insbesondere darin, dass ebenfalls eine Infrarotkamera 40 vorgesehen ist, die auf eine Druckmaskenoberfläche 10 gerichtet ist und eine Thermografieaufnahme 12 erstellt, die dann analog zu Figur 1 einer Anlagensteuerung 22 mit einem Computersystem 24 zugefügt wird. Der Abgleich der Abbildung 8 und der Thermografieaufnahme 12 erfolgt analog wie in Figur 1 beschrieben.

In Figur 3 ist eine Druckmaske 2, die aus Edelstahl besteht, dargestellt. Diese Druckmaske 2 weist Abdeckbereiche 4 auf und sie umfasst Aperturöffnungen 6. Durch die Aperturöffnung 6 wird die Druckpaste 32, beispielsweise eine Lotpaste, auf das darunter liegende Substrat, beispielsweise eine Leiterplatte 30, gepresst. Die Druckmaske 2 weist dabei Justierpunkte 14 auf, die sehr unterschiedlich ausgestaltet sein können. Hier sind schematisch zwei Kreise dargestellt, es können jedoch auch Kreuze oder lediglich ein Kreuz sein, auch zwei charakteristisch zueinander liegende Aperturöffnungen 6 können als Justierpunkte 14 herangezogen werden. Die Justierpunkte 14 dienen dazu, die Abbildung 8 und die Infrarotaufnahme 12 elektronisch kongruent übereinander zu legen und zu justieren.

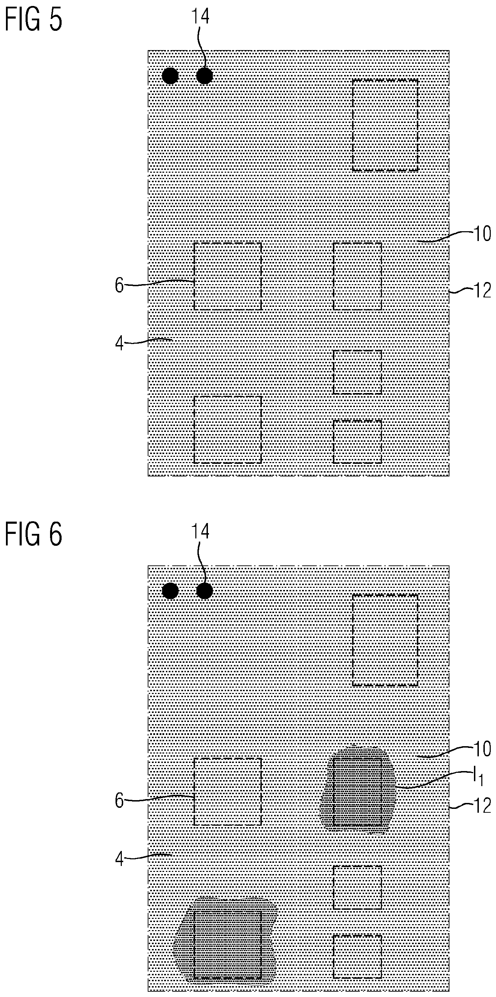

In Figur 4 ist ein vergrößerter Ausschnitt des Rechteckes mit der Bezeichnung IV gegeben. Diese vergrößerte Darstellung gemäß Figur 4 wird in den folgenden Figuren rein exemplarisch weiterverfolgt. Bei der Figur 4 handelt es sich um den Ausschnitt der Abbildung 8 der Druckmaske 2 in vergrößerter Form. In den darauffolgenden Figuren 5 bis 9 wird jeweils dieser Ausschnitt in Form einer Thermografieaufnahme gezeigt.

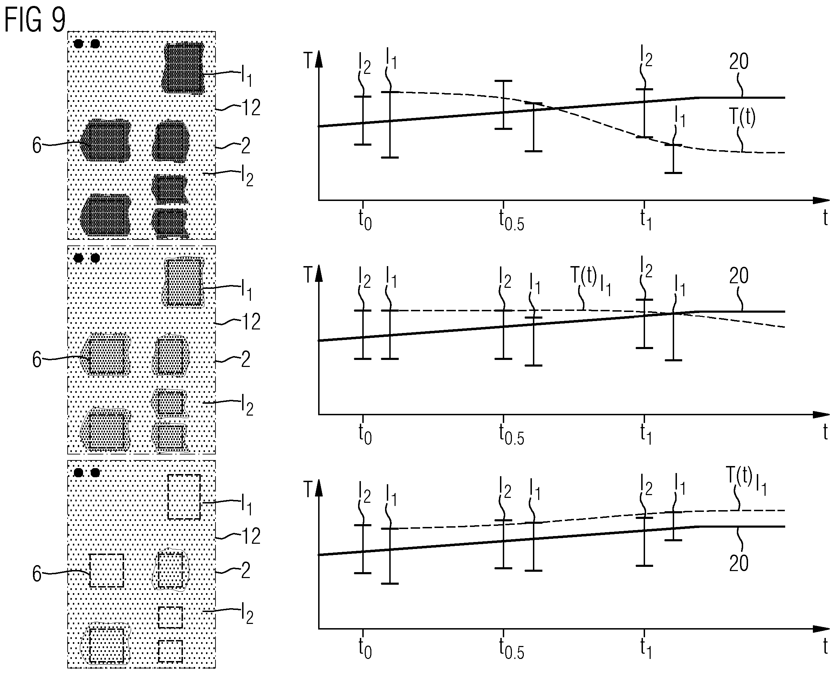

In Figur 5 ist eine Thermografieaufnahme 12 einer Druckmaske 2 gegeben, die für den Prozess bestmöglich gereinigt ist oder sogar aus ihrem Ausgangszustand als neue Druckmaske hervorgeht. Es liegen in den Aperturöffnungen 6 keine Verunreinigungen vor. Die Thermografieaufnahme 12 dieser Druckmaske ist weitgehend einheitlich, es lassen sich keine Temperaturanomalien I₁ erkennen. Im Gegensatz dazu ist in Figur 6 eine verunreinigte Druckmaske 2 dargestellt, wobei Verunreinigungen an zwei Aperturöffnungen 6 anhand von Temperaturanomalien I₁ erkennbar sind. In diesen Bereichen sind Reste von Druckpaste 32 und/oder Reinigungsmitteln vorhanden, die mit der Zeit verdampfen und beim Verdampfen aufgrund der benötigen Verdampfungsenthalpie ihrer Umgebung Wärme entziehen. Dieser Wärmeentzug führt zu geringfügig geringeren Temperaturen im Umfeld dieser Verunreinigungen, die auf den Thermografieaufnahmen 12 zu erkennen sind. Typische Temperaturunterschiede, die die Temperaturanomalien bilden liegen zwischen 0,3° K und 3° K. Dabei ist anzumerken, dass diese Temperaturanomalien I₁ keine exakten Temperaturplateaus darstellen, sondern auch hier innerhalb dieser Anomalie eine Schwankung auftritt. Daher ist es zweckmäßig, Temperaturintervalle I₂ einzuführen, auf dessen Wirkung insbesondere in Figur 9 noch näher eingegangen wird.

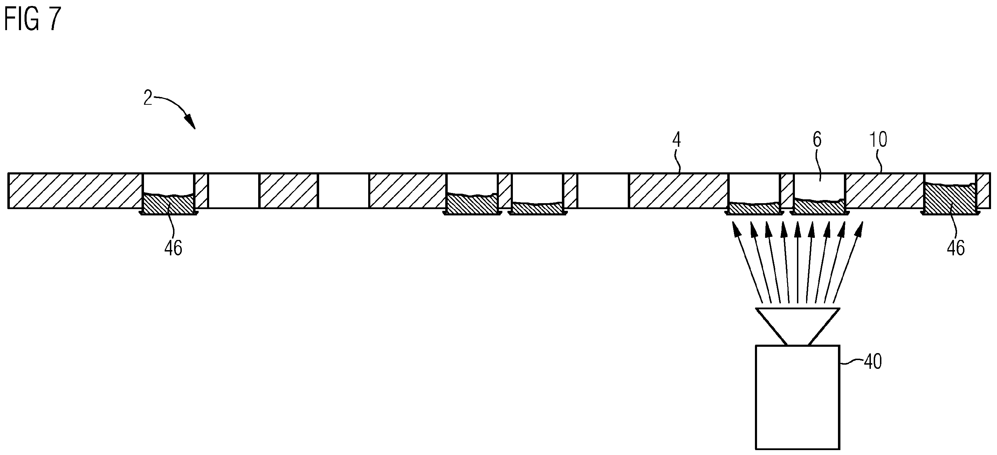

Zunächst ist in Figur 7 noch einmal eine Anordnung einer Infrarotkamera 40 bezüglich einer Druckmaske 2 im Querschnitt dargestellt. Hierbei ist zu erkennen, dass in den Aperturöffnungen 6 Reste von Reinigungsmitteln 46 vorhanden sind. Diese Reste 46 führen zu den beschriebenen Temperaturanomalien I₁. In der Figur 8 ist alternativ zu den Reinigungsmittelresten 46 in Figur 7 eine Querschnittsdarstellung von Druckmasken 2 gegeben, in denen Reste von Pasten 48 in den Aperturöffnungen 6 eingelagert sind. Grundsätzlich ist es auch möglich, dass sowohl Reinigungsmittelreste 46 und Pastenreste 48 in einer Aperturöffnung 6 gemeinsam vorliegen.

**In** **Figur 8** sind übereinander drei unterschiedliche Verunreinigungsgrade von Druckmasken 2 dargestellt. Die Druckmaske 2a ist noch gut für die weitere Nutzung im Druckvorgang geeignet. Die Maske 2 im Zustand b sollte bald gereinigt werden und die Druckmaske 2 im Zustand c muss gereinigt werden, um einen weiteren Druckvorgang durchzuführen. Die Druckmasken 2a, 2b und 2c korrespondieren jeweils mit einer schematisch dargestellten Thermografieaufnahme, wobei zu erkennen ist, dass die Maske 2a eine Thermografieaufnahme 12 a aufweist, die nur sehr geringe Temperaturanomalien I₁ aufweist. Bei der Thermografieaufnahme 12 zu Figur 8b sind die Temperaturanomalien I₁ schon deutlich stärker zu erkennen und bei der Druckmaske aus Figur 8c sind starke Temperaturanomalien I₁ sichtbar.

Nun stellt sich jedoch die Frage, wie eine Auswerteeinheit in der Anlagensteuerung 22 bzw. in dem Computersystem 24 diese unterschiedlichen Temperaturanomalien in der Thermografieaufnahme 12 werten soll. Daher ist es beispielsweise zweckmäßig, ein Temperaturintervall I₂ anzugeben, in dessen Bereich sich die Temperaturanomalien I₁ bewegen dürfen, wenn keine erheblichen Verunreinigungen vorliegen. Dies ist in Figur 9 skizziert. Hierbei sind dieselben Thermografieaufnahmen, die bereits in Figur 8a, b, c abgebildet sind, wiederholt. Diese Thermografieaufnahmen 12 korrespondieren dabei jeweils mit einem Temperatur-Zeit-Verlauf, der jeweils direkt rechts daneben zu der Thermografieaufnahme 12 dargestellt ist.

In Figur 9a ist die Thermografieaufnahme 12 der sauberen, kaum verunreinigten Druckschablone 2 dargestellt. Wie bereits beschrieben, sind hier kaum Temperaturanomalien I₁ zu erkennen. Das ist in dem Graphen auf der rechten Seite neben der Thermografieaufnahme 12 zu erkennen. Hier ist nämlich ein Temperaturintervall I₂ dem Intervalls der Temperaturunterschiede in den Temperaturanomalien I₁ gegenübergestellt. Hierbei ist anzumerken, dass es sich hier jeweils um eine Festlegung eines Intervalls handelt, die auf empirische Werte zurückzuführen sind. Ferner ist zu beachten, dass sich die Temperaturen auf der Oberfläche 10 der Druckmaske 2 mit der Zeit t verändern und sich gegebenenfalls in einen konstanten Bereich einpendeln. Hierzu wird ein Zeitpunkt t₀ definiert, der mit einem bestimmten Ereignis, wie beispielsweise einem letzten Druckprozess oder das Ende des Trocknens bei einem Reinigungsprozess korreliert. Um die Thermografieaufnahmen 12 miteinander vergleichen zu können, ist es zweckmäßig einen konstanten Zeitabschnitt zu einem Zeitpunkt t₁ zu definieren. Dies kann beispielsweise 0,5 Sekunden oder 1 Sekunde, jedoch auch ein längerer Abschnitt von 10 oder 15 Sekunden sein. In dieser Zeitspanne wird restliches Reinigungsmittel oder Pastenreste anfangen zu verdampfen und der Umgebung um die Aperturöffnung 6 Wärme entziehen, sodass an dieser Stelle die Temperaturen verringert sein werden und auf der Thermografieaufnahme 12 leicht reduzierte Temperaturen vorliegen.

Da es bei den Temperaturanomalien immer zu Schwankungen kommt und kein exakter einheitlicher Wert vorliegt, wird eben jeweils von einem Intervall bzw. einem unteren und oberen Schwellwert gesprochen, der festlegt, ob es sich um eine Temperaturanomalie handelt, die außerhalb eines festgelegten Temperaturintervalls I₂ liegt. Bei der sauberen Druckmaske 2 nach Figur 9a sieht man den zeitlichen Verlauf zwischen t₀ über t_{0,5} bis zu t₁, da sowohl die im Bereich der Aperturöffnungen gemessene Temperaturverteilung I₁ und das Temperaturintervall I₂ im Wesentlichen aufeinander fallen. Insofern kann in dieser Darstellung nicht von einer Temperaturanomalie in dem weiteren verwendeten Sinne gesprochen werden, da eben keine Anomalie an sich vorliegt. Diese Temperaturanomalie I₁ hingegen ist bereits in der Figur 9b zu erkennen, wo im Laufe der Zeit zwischen dem Zeitpunkt t₀ über t_{0,5} auf t₁ im Bereich der Aperturöffnungen 6 deutlich verringerte Temperaturen messbar sind, die sich durch die hier dargestellte Temperaturanomalie I₁ zum Zeitpunkt t₁ bemerkbar macht. Auch hier handelt es sich innerhalb dieser Temperaturanomalie I₁ nicht um einen konstanten Wert, sondern ebenfalls um einen Temperaturbereich, der zumindest zu einem größeren Teil nicht mehr mit dem Temperaturintervall I₂ übereinander fällt, sondern aufgrund der beschriebenen Verdampfungsenthalpie niedriger liegt.

In der Figur 9c sind die Aperturöffnungen 6 der Druckschablone 2 so stark verunreinigt, dass eine starke Verdampfung von Pastenresten bzw. Reinigungsmitteln eintritt, sodass das Temperaturintervall der Temperaturanomalien I₁ unter dem Temperaturintervall I₂ liegt. Nun kann aufgrund von Erfahrungswerten in einem Computerprogramm, das in der Anlagensteuerung 22 bzw. im Computersystem 24 implementiert ist, festgelegt sein, wann eine Prozessbeeinflussungsmaßnahme eingeleitet werden muss, wenn sich die Temperaturanomalie I₁ und das Temperaturintervall I₂ zu einem bestimmten Grad nicht mehr übereinanderliegen.

Ferner kann es auch zweckmäßig sein, anstatt ein, zwei oder drei Thermografieaufnahmen 12 zu den Zeitpunkten t₀, t_{0,5} und t₁ oder nur t₁ darzustellen, auch eine gesamte Videoaufnahme über einen Zeitraum zwischen t₀ bis zum Zeitpunkt t₁ ist mit einfachen technischen Mitteln möglich. Hierbei ist es zweckmäßig einen Referenzverlauf 20 anzugeben, der hier lediglich der Übersichtlichkeit halber in einer einzigen Kurve besteht. Auch dieser Referenzverlauf 20 in den Figuren 9a bis 9c kann wie das Temperaturintervall I₂ jeweils eine Obergrenze und eine Untergrenze der Temperatur aufweisen. Analog kann hierzu, wie in Figur 9 gestrichelt dargestellt ist, der niedrigste Temperaturwert oder der höchste Temperaturwert im Bereich der **Temperaturanomalie** I₁ (hier gestrichelt dargestellt) vermittelt werden. Liegt dieser gestrichelte Wert der die Funktion T (t) I₁ beschreibt, stets über dem Referenzwert 20, so kann davon ausgegangen werden, dass die Druckschablone 2 weiterhin einsatzfähig ist. Dies ist in der Figur 9a so veranschaulicht. In Figur 9b liegt diese gestrichelte Kurve zum Zeitpunkt t₁ mit dem Referenzwert 20 aufeinander, weshalb an dieser Stelle bereits eine Maßnahme zur Beeinflussung des Druckprozesses eingeleitet werden kann. In Figur 9c liegt die gestrichelte Linie unter dem Referenzwert 20, sodass hier eine Reinigung der Druckmaske 2 durchgeführt werden muss.

### Bezugszeichenliste

- 2: Druckmaske
- 4: Abdeckbereich
- 6: Apparaturöffnung
- 8: Abbildung
- 10: Druckmaskenoberfläche
- 14: Justierpunkte
- 12: Thermographieaufnahmen
- I₁: Temperaturanomalien
- I₂: Temperaturintervall
- 16: Reinigung
- 18: Trocknung
- 20: Referenzverlauf
- 22: Anlagensteuerung
- 24: Computersystem
- 26: Druckanlage
- 28: Reinigungsanlage
- 30: Leiterplatten
- 32: Lotpaste
- 34: Rakel
- 36: Druckrahmen
- 38: Förderband
- 40: Infrarotkamera
- 42: Spülung
- 44: Trocknung
- 46: Rest Reinigungsmittel
- 48: Rest Paste

## Patentansprüche

1. Verfahren zur Überwachung der Druckbereitschaft einer Druckmaske (2) mit Abdeckbereichen (4) und Aperturöffnungen (6), umfassend folgende Schritte:
- Erzeugen einer Abbildung (8) der Druckmaskenoberfläche (10),
- Erfassung einer Thermografieaufnahme (12) der Druckmaskenoberfläche (10)
- Festlegen von Justierpunkten (14) auf der Druckmaskenoberfläche (10), die auf der Abbildung (8) und auf der Thermografieaufnahme (12) identifizierbar sind,
- Überlagern der Abbildung (8) und der Thermografieaufnahme (12) anhand der Justierpunkte (14)
- Vergleichen der Position von Temperaturanomalien (I₁) auf der Druckmaskenoberfläche (10), die mittels der Thermografieaufnahme (14) identifiziert werden mit der Position von Aperturöffnungen (6) auf der Abbildung (8),
- Festlegen eines Temperaturintervalls (I₂) für die Temperaturanomalien (I₁)
- Einleitung von Prozessbeeinflussungsmaßnahmen, wenn die Temperaturanomalien (I₁) zumindest teilweise außerhalb des Temperaturintervalls (I₂) liegen.

2. Verfahren nach Anspruch 1, **dadurch gekennzeichnet, dass** die Prozessbeeinflussungsmaßnahme die Reinigung (16) oder Trocknung (18) der Druckmaske (2) ist.

3. Verfahren nach Anspruch 1 oder 2, **dadurch gekennzeichnet, dass** die Prozessbeeinflussungsmaßnahme eine Veränderung einer Rakelgeschwindigkeit oder eines Rakeldrucks ist,

4. Verfahren nach einem der Ansprüche 1 bis 3, **dadurch gekennzeichnet, dass** die Thermografieaufnahme (12) nach einer Zeit (t₁) nach einem Ereignis zum Zeitpunkt (t₀) durchgeführt wird.

5. Verfahren nach Anspruch 4, **dadurch gekennzeichnet, dass** mehrere ThermografieAufnahmen (12) im Zeitraum zwischen (t₀) und (t₁) durchgeführt werden.

6. Verfahren nach Anspruch 4, **dadurch gekennzeichnet, dass** ein Referenzverlauf (20) einer Temperatur-Zeit-Kurve an einer definierten Aperturöffnung (4-1) aufgenommen wird und mit dem betrachteten Temperatur-Zeit-Verlauf (T(t)-I₁) verglichen wird.

7. Verfahren nach Anspruch 5, **dadurch gekennzeichnet, dass** das Temperaturintervall (I₂) als ein Toleranzbereich des Referenzverlaufs (20) definiert wird, und die Maßnahme eingeleitet wird, wenn der betrachtete Temperatur-Zeit-Verlauf (T(t)-I₁) zumindest teilweise außerhalb des Toleranzbereichs (I₂) liegt.

8. Verfahren nach einem der vorhergehenden Ansprüche, **dadurch gekennzeichnet, dass** eine Anlagensteuerung (22) vorgesehen ist und eine elektronische Auswertung und Überlagerung der Abbildung (8) und der Thermografieaufnahme (12) auf einem Computersystem (24) erfolgt, das an die Anlagensteuerung (22) angeschlossen ist oder in diese integriert ist.

9. Verfahren nach einem der vorhergehenden Ansprüche **dadurch gekennzeichnet, dass** das Verfahren in einer Druckanlage (26) oder in einer Reinigungsanlage (28) durchgeführt wird.

10. Verfahren nach Anspruch 8, **dadurch gekennzeichnet, dass** die Anlage eine Druckanlage (26) zum Bedrucken von Leiterplatten (30) mit einer Lotpaste (32) ist.

11. Computerprogramm umfassend einen digitalen Zwilling zur Steuerung eines Verfahrens zur Überwachung der Druckbereitschaft einer Druckmaske (2) nach einem der Ansprüche 1 bis 10, in dem die Abbildung (8) als digitale Abbildung (8) vorliegt und die Aperturöffnung (6) sowie die Justierpunkte (14) als Bestandteil der digitalen Abbildung (8) gespeichert sind und eine Thermografieaufnahme (12) einlesbar ist.

12. Computersystem mit einem Computerprogramm nach Anspruch 11.

## Claims

1. Method for monitoring the print readiness of a print stencil (2) having cover regions (4) and aperture openings (6), comprising the following steps:
- generating an image (8) of the print stencil surface (10),
- capturing a thermographic image (12) of the print stencil surface (10),
- on the print stencil surface (10), defining adjustment points (14) which are identifiable in the image (8) and in the thermographic image (12),
- overlaying the image (8) and the thermographic image (12) on the basis of the adjustment points (14),
- comparing the position of temperature anomalies (I₁) on the print stencil surface (10), which are identified by means of the thermographic image (14), with the position of aperture openings (6) in the image (8),
- defining a temperature interval (I₂) for the temperature anomalies (I₁),
- initiating process influencing measures should the temperature anomalies (I₁) be at least partly outside the temperature interval (I₂).

2. Method according to Claim 1, **characterized in that** the process influencing measure is the cleaning (16) or drying (18) of the print stencil (2).

3. Method according to Claim 1 or 2, **characterized in that** the process influencing measure is a change in a squeegee speed or a squeegee pressure.

4. Method according to any of Claims 1 to 3, **characterized in that** the thermographic image (12) is taken after a time (t₁) following an event at the time (t₀).

5. Method according to Claim 4, **characterized in that** a plurality of thermographic images (12) are taken in the time period between (t₀) and (t₁).

6. Method according to Claim 4, **characterized in that** a reference profile (20) of a temperature-time curve is recorded at a defined aperture opening (4-1) and compared with the temperature-time profile (T(t)-I₁) in question.

7. Method according to Claim 5, **characterized in that** the temperature interval (I₂) is defined as a tolerance range of the reference profile (20), and the measure is initiated should the temperature-time profile (T(t)-I₁) in question lie at least partly outside the tolerance range (I₂).

8. Method according to any of the preceding claims, **characterized in that** an apparatus controller (22) is provided, and the image (8) and the thermographic image (12) are electronically evaluated and overlaid in a computer system (24) which is connected to or integrated into the apparatus controller (22).

9. Method according to any of the preceding claims, **characterized in that** the method is carried out in a printing apparatus (26) or in a cleaning apparatus (28).

10. Method according to Claim 8, **characterized in that** the apparatus is a printing apparatus (26) for printing printed circuit boards (30) with a solder paste (32).

11. Computer program comprising a digital twin for controlling a method for monitoring the print readiness of a print stencil (2) according to any of Claims 1 to 10, wherein the image (8) is present as a digital image (8), and the aperture opening (6) and the adjustment points (14) are stored as a constituent part of the digital image (8), and a thermographic image (12) can be read in.

12. Computer system having a computer program according to Claim 11.

## Revendications

1. Procédé de surveillance de la disponibilité de pression d'un masque d'impression (2) avec des zones de recouvrement (4) et des ouvertures (6), comprenant les étapes suivantes :
- création d'une reproduction (8) de la surface du masque d'impression (10),
- détection d'un cliché de thermographie (12) de la surface du masque d'impression (10),
- détermination de points d'ajustement (14) de la surface du masque d'impression (10) qui sont identifiables sur la reproduction (8) et sur le cliché de thermographie (12),
- superposition de la reproduction (8) et du cliché de thermographie (12) à l'aide des points d'ajustement (14),
- comparaison de la position d'anomalies de température (I₁) sur la surface du masque d'impression (10) qui sont identifiées au moyen du cliché de thermographie (14) avec la position d'ouvertures (6) sur la reproduction (8),
- détermination d'un intervalle de température (I₂) pour les anomalies de température (I₁),
- introduction de mesures d'influence du procédé lorsque les anomalies de température (I₁) sont situées au moins partiellement en-dehors de l'intervalle de température (I₂).

2. Procédé selon la revendication 1, **caractérisé en ce que** la mesure d'influence du procédé est le nettoyage (16) ou le séchage (18) du masque d'impression (2).

3. Procédé selon la revendication 1 ou 2, **caractérisé en ce que** la mesure d'influence du procédé est une modification d'une vitesse de racloir ou d'une pression de racloir.

4. Procédé selon l'une des revendications 1 à 3,
**caractérisé en ce que** le cliché de thermographie (12) est exécuté après un temps (t₁) après un évènement jusqu'au moment (t₀).

5. Procédé selon la revendication 4, **caractérisé en ce que** plusieurs clichés de thermographie (12) sont exécutés dans la période entre (t₀) et (t₁).

6. Procédé selon la revendication 4, **caractérisé en ce qu'**un tracé de référence (20) d'une courbe température-temps est pris à une ouverture définie (4-1) et comparé au tracé température-temps (T(t)-I₁) considéré.

7. Procédé selon la revendication 5, **caractérisé en ce que** l'intervalle de température (I₂) est défini en tant qu'une plage de tolérance du tracé de référence (20) et la mesure est introduite lorsque le tracé température-temps (T(t)-I₁) considéré est au moins partiellement en-dehors de la plage de tolérance (I₂).

8. Procédé selon l'une des revendications précédentes, **caractérisé en ce qu'**une commande de l'installation (22) est prévue, et une évaluation et une superposition électroniques de la reproduction (8) et du cliché de thermographie (12) sont effectuées sur un système informatique (24) qui est raccordé à la commande de l'installation (22) ou intégré dans celle-ci.

9. Procédé selon l'une des revendications précédentes, **caractérisé en ce que** le procédé est exécuté dans une installation d'impression (26) ou une installation de nettoyage (28) .

10. Procédé selon la revendication 8, **caractérisé en ce que** l'installation est une installation d'impression (26) pour imprimer des circuits imprimés (30) avec une pâte à braser (32).

11. Programme informatique comprenant un jumeau numérique pour commander un procédé de surveillance de la disponibilité de pression d'un masque d'impression (2) selon l'une des revendications 1 à 10, dans lequel la reproduction (8) est présente sous forme d'une reproduction numérique (8) et l'ouverture (6) ainsi que les points d'ajustement (14) sont en mémoire en tant que composante de la reproduction numérique (8) et un cliché de thermographie (12) peut être lu.

12. Système informatique comprenant un programme informatique selon la revendication 11.
